# EUROPÄISCHE PATENTSCHRIFT

(11) **EP 1 069 453 B1**
(45) Veröffentlichungstag und Bekanntmachung des Hinweises auf die Patenterteilung: **15.09.2004**
(21) Anmeldenummer: 00112846.1
(22) Anmeldetag: 17.06.2000
(51) Int. Cl.: G02B 27/14, H01S 3/00, G03F 7/20

(54) **Vorrichtung zur Reduzierung der Peakleistung einer Pulslaser-Lichtquelle**
Device for reducing the peak output of a pulse laser light source
Dispositif de reduction de la sortie maximale d'une source de lumière à laser d'impulsion

(30) Priorität: 08.07.1999 DE 19931751
(43) Veröffentlichungstag der Anmeldung: 17.01.2001
(73) Patentinhaber: Carl Zeiss SMT AG, 73447 Oberkochen (DE)
(72) Erfinder: Schuster, Karl-Heinz, 89551 Koenigsbronn (DE)
(74) Vertreter: Lorenz, Werner, Dr.-Ing.

(56) Entgegenhaltungen:
- US-A- 5 233 460
- US-A- 5 315 604
- US-A- 5 337 333
- US-A- 5 559 816

## Beschreibung

Die Erfindung betrifft eine Projektionsbelichtungsanlage mit einer Vorrichtung zur Reduzierung der Peakleistung einer Pulslaser-Lichtquelle.

Pulslaser-Lichtquellen, z.B. Excimer-Laser, für die UV-Lithographie besitzen eine Wiederholungsrate von etwa 1000 bis 4000 Pulsen pro Sekunde. Die Pulslänge beträgt derzeit 20 bis 30 ns. Innerhalb eines jeden Pulses kommt es in der Abhängigkeit vom Gaszustand, vom Zustand des Lasers, insbesondere der optischen Komponenten, und abhängig von der Resonatorlänge zu erheblichen Modulationen der Laserausgangsleistung über die Zeit.

Dabei hat sich in der Praxis herausgestellt, dass ein deutlicher Nachteil einer Pulslaser-Lichtquelle darin besteht, dass die kurze Pulsdauer eine hohe Pulsleistungsdichte verursacht, die sich auf die optischen Materialien, insbesondere glasige Materialien, sehr negativ auswirkt. Quarzglas bei einer Arbeitswellenlänge von 193 nm wird mit einer Rate, in die eine Potenz der Leistungsdichte eingeht geschädigt. Die Folgen daraus sind Transmissionsverluste und eine unkontrollierte Erhöhung der Brechzahl was die Lebensdauer des optischen Systems begrenzt. Bei SiO₂ in glasiger Form gibt es Stellen mit besonders schwachen Bindungen. Die von der Pulslaser-Lichtquelle erzeugten gepulsten kurzwelligen elektromagnetischen Strahlungen liefern damit die Energie, um in nachteiliger Weise diese Stellen zu modifizieren.

Aus der EP 0 785 473 A2 ist eine Vorrichtung der eingangs erwähnten Art bekannt, durch die das von einer Pulslaser-Lichtquelle kommende Licht in mehrere Teilstrahlen aufgeteilt wird, welche Umwegleitungen durchlaufen. Auf diese Weise erfolgt eine Bündel-Aufweitung bzw. eine Aufteilung in mehrere nebeneinander angeordnete Teilstrahlen. Diese Teilstrahlen werden nebeneinander angeordnet in eine Beleuchtungseinrichtung eingegeben.

Nachteilig dabei ist jedoch, dass damit mehrere optische Achsen nebeneinander erzeugt werden und die Beleuchtungseinrichtung entsprechend anzupassen ist. Darüber hinaus liegt die vorgenannte Vorrichtung in ihrer Ausrichtung fest.

In der US-A 5 661748 ist eine Pulsverzögerungseinrichtung mit teildurchlässigen Spiegeln und zwangsläufigen "Schwanz" der Pulsverteilung und eine Anordnung mit zwei Konkavspiegeln und einem gerasterten Spiegel beschrieben, bei dem prinzipiell ein Versatz (Teil 4.2) auftritt, der nicht durch den schrägen Durchtritt durch Planplatten entsteht.

Die US-A 5 337 333 bezieht sich auf eine Vorrichtung zur Reduzierung der Peakleistung einer Pulslaserlichtquelle für die X-Ray-Lithographie.

Die US-A 4 941 093 beschreibt einen Laser zur Strahlformung zum Erudieren einer Oberfläche, wobei in dem Bearbeitungsstrahl ein Teleskop, bestehend aus zwei konvergierenden Linsen, angeordnet ist, um den Laserstrahl auf die gestellten Anforderungen hin zu optimieren.

Der vorliegenden Erfindung liegt daher die Aufgabe zugrunde, eine Vorrichtung zu schaffen, mit deren Hilfe Schädigungen von Bauteilen, die im Strahlengang der Pulslaser-Lichtquelle liegen, vermieden werden und zwar möglichst ohne besondere Einbuße des Wirkungsgrades der Pulslaser-Lichtquelle.

Erfindungsgemäß wird diese Aufgabe durch die im Anspruch 1 genannten Maßnahmen gelöst.

Erfindungsgemäß werden nun die hohen Spitzen bzw. Peaks der Pulslaser-Lichtquelle abgebaut und die Pulsleistungsdichte verringert, und zwar bei nur geringer integraler Energieeinbuße. Durch die Strahlteilung in Verbindung mit der Umwegleitung erfolgt eine Aufteilung des Strahles der Pulslaser-Lichtquelle in Teilstrahlen mit einem optischen Gangunterschied. Dabei ist lediglich dafür zu sorgen, dass der Gangunterschied so gewählt wird, dass sich wenigstens weitgehend Spitzen und Täler ergänzen. Spitzen und Täler liegen zeitlich auseinander, z.B. 7,0 ns. Dies entspricht einem Laufweg des Lichts von 2,1 m. Um ganze Pulse in ihrer Pulsleistungsdichte zu halbieren, werden sie in mehrere Pulse aufgeteilt und dann zeitlich aneinander gereiht. Um eine möglichst große Reduzierung der Spitzen innerhalb eines Pulses und eine weitgehend gleichmäßige Leistungsdichte zu erzeugen, wird in einer vorteilhaften Ausgestaltung der Erfindung vorgeschlagen, wenigstens zwei Umwegleitungen im Strahlengang hintereinander anzuordnen.

Erfindungsgemäß werden nicht mehrere Teilstrahlen erzeugt, die nebeneinander angeordnet sind mit einer entsprechenden Anzahl von optischen Achsen, sondern es erfolgt eine Wiedervereinigung der Teilstrahlen zu einem Gesamtstrahl, womit eine einheitliche optische Achse für die nachfolgende Beleuchtungseinrichtung gegeben ist. Es findet nach der Teilung in mehrere Teilstrahlen abschließend wieder eine Auffädelung statt.

Die erfindungsgemäße Vorrichtung Rässt sich für die Beeinflussung von polarisiertem Licht einsetzen, wozu entsprechend zwischen dem Strahlengang und der Strahlteilereinrichtung ein Winkel, nämlich der Brewster-Winkel in Verbindung mit einem leicht verstimmten Kepler-Fernrohr, vorgesehen wird. Durch den Brewster-Winkel wird erreicht, dass durch die Strahlteilereinrichtung, z.B. einem Spiegel, 50 % des Strahles ungehindert und verlustfrei hindurchgehen (von Absorption in der Teilerschicht abgesehen), während die anderen 50 % abgeleitet werden. Selbstverständlich sind alternativ zur Erfindung jedoch auch noch andere Winkel und damit auch noch andere Aufteilungsprozente möglich.

In einer weiteren Ausgestaltung der Erfindung kann vorgesehen sein, dass das Strahlvereinigungsglied derart ausgebildet ist, dass ein Teil des Teilstrahles, der über die Umwegleitung gelaufen ist, wiederholt über die Umwegleitung geschickt wird.

Auf diese Weise lassen sich noch mehrere optische Gangunterschiede und damit eine noch stärkere Vergleichmäßigung erreichen. Natürlich kommen noch zusätzliche Verluste aus Spiegel und Teiler zum Tragen.

Durch eine Phasenverzögerungsplatte im Strahlengang erhält man eine Beeinflussung der Leistungsspitzen und der Lebensdauer der optischen Materialien, die der Pulslaser-Lichtquelle ausgesetzt sind.

Weitere vorteilhafte Ausgestaltungen und Weiterbildungen ergeben sich aus den übrigen Unteransprüchen und aus dem nachfolgend anhand der Zeichnung prinzipmäßig beschriebenen Ausführungsbeispiel.

Es zeigt:
- Figur 1: eine Prinzipdarstellung des Strahlenganges einer Pulslaser-Lichtquelle mit zwei Umwegleitungen;
- Figur 2: die Leistung der Pulslaser-Lichtquelle im Aufteilungszustand durch eine erste Umwegleitung;
- Figur 3: den Leistungsverlauf der Pulslaser-Lichtquelle nach einer zweiten Umwegleitung;
- Figur 4: eine weitere Ausführungsform einer Umwegleitung in schematischer Darstellung; und
- Figur 5: eine Prinzipdarstellung einer erfindungsgemäßen Projektionsbelichtungsanlage mit einem Excimer-Laser und der beschriebenen Vorrichtung.

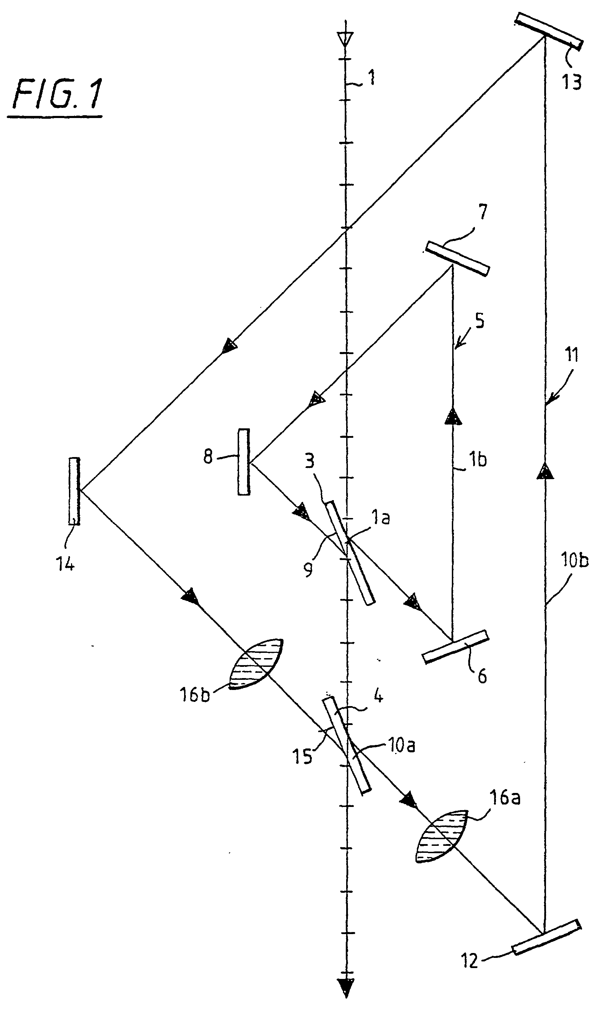

Gemäß der Darstellung in Figur 1 trifft ein Strahlenbündel 1 einer Pulslaser-Lichtquelle, z.B. eines Excimer-Laser 2 (dargestellt in der Figur 5) auf eine erste Strahlteilereinrichtung in Form eines Spiegels 3. 50 % des gesamten Strahles passieren als Teilstrahl 1a ungehindert und verlustfrei den Teilerspiegel 3 in Richtung auf einen zweiten Teilerspiegel 4 als zweite Strahlteilereinrichtung. Die anderen 50 % des Strahles nehmen ihren Weg als Teilstrahl 1b über eine Umwegleitung 5, die durch drei Spiegel 6, 7 und 8 als reflektierende Bauteile gebildet ist. Der Teilerspiegel 3 als erste Strahlteilereinrichtung wirkt auf seiner Rückseite auch gleichzeitig als Strahlvereinigungsglied 9, in welchem der Teilstrahl 1b mit dem durch die Strahlteilereinrichtung durchgehenden Teilstrahl la wieder vereinigt wird. Durch die erste Umwegleitung 5 wird der Puls der Pulslaser-Lichtquelle 2 in sich geglättet. Gleichzeitig wird dabei die Spitzenleistung um 30 bis 40 % verringert. Aufgrund der Winkellage des Teilerspiegels 3 bzw. der ersten Umwegleitung 5 zur Schwingungsrichtung des einfallenden linear polarisierten Laserlichtes spielt die Höhe des Polarisierungsgrades für die Energiebilanz keine Rolle. Beide Teilstrahlen 1a und 1b sind am Ausgang der ersten Umwegleitung 5 gleich polarisiert, jedoch zeitlich versetzt.

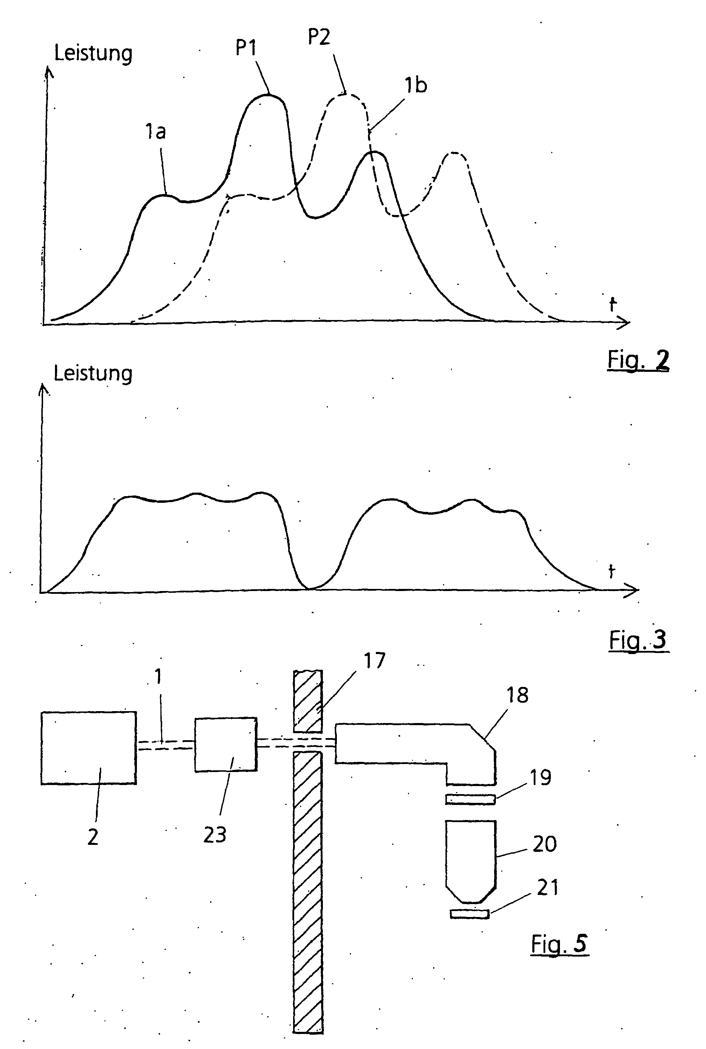

Aus der Figur 2 ist der zeitliche Versatz der beiden Teilstrahlen 1a und 1b erkennbar. Wie ersichtlich, ist somit die Peakleistung der Pulslaser-Lichtquelle, die aufgrund der Strahlteilung auf jeweils die Hälfte reduziert worden ist, bei einer Addition aufgrund des zeitlichen Versatzes der beiden "Peaks" P1 und P2 entsprechend in dem daraus resultierenden Gesamtpeak im Vergleich zu einem unbehandelten Strahlengang reduziert.

Der Laserlichtstrahl wird nach der Wiedervereinigung der beiden Teilstrahlen 1a und 1b im weiteren Strahlengang durch die zweite Strahlteilereinrichtung in Form des Teilerspiegels 4, der wiederum 45° gedreht (Brewster-Winkel) zur Schwingungsrichtung des Laserlichtes liegt, in den Teilstrahl 10a, der den Teilerspiegel 4 ungehindert passiert, und den Teilstrahl 10b, der über eine zweite Umwegleitung 11 geschickt wird, aufgeteilt. Die zweite Umwegleitung 11 wird ebenfalls durch Spiegel 12, 13 und 14 als reflektierende Bauteile gebildet. Die Rückseite des Strahlteilers 4 dient wiederum als zweites Strahlvereinigungsglied 15, durch das die beiden Teilstrahlen 10a und 10b wieder bei gleicher Polarisationsrichtung zusammengesetzt und anschließend gemeinsam weitergeschickt werden.

Durch die zweite Umwegleitung 11, die z.B. einen Laufweg von 11,1 m besitzen kann, wird der Puls der Pulslaser-Lichtquelle 2 als ganzes versetzt. Auf diese Weise erhält man am Ausgang bzw. an dem Strahlvereinigungsglied 15 zwei Pulse mit gleicher Polarisation, die weitgehend geglättet sind bzw. keine unzulässig hohen "Peaks" mehr aufweisen, die zu Schädigungen von Bauteilen führen könnten.

Aus der Figur 3 sind die Leistung über der Zeit und die zwei Pulse ersichtlich, wie sie nach dem Strahlvereinigungsglied 15 vorliegen. Die ursprüngliche Leistungsspitze kann dabei auf etwa ein Drittel des ursprünglichen Wertes reduziert werden. Beträgt beispielsweise die zeitliche Pulsdauer der Pulslaser-Lichtquelle 30 ns, so entspricht dies einem Laufweg des Lichtes von 9 m. Kombiniert man gemäß dem Ausführungsbeispiel die erste Umwegleitung 5 mit der zweiten Umwegleitung 11, so wird einmal 2,1 m verzögert und der auf diese Weise geglättete Impuls 9,0 m + 2,1 m, also insgesamt 11,1 m verzögert in der zweiten Umwegleitung 11.

Für die erfindungsgemäßen Maßnahmen eignen sich am besten Bereiche zwischen dem Laserausgang und einem Scannereingang.

Der besondere Vorteil der Erfindung liegt nun darin, dass die nachfolgende Beleuchtungseinheit nicht speziell ausgelegt werden muss, sondern die vorgeschlagene Einrichtung lediglich zwischen Laserausgang und Eingang des Beleuchtungsteils eines Scanners eingefügt wird. Damit wird auch eine wirtschaftliche Nachrüstung bestehender Systeme möglich (kein neuer Beleuchtungsteil des Scanners).

Da die Strahlqualität der Pulslaser-Lichtquelle durch die unterschiedlichen Weglängen Reiden kann, wird diese z.B. durch ein Kepler-Fernrohr (im Einzelfall auf die Excimerlaser-Divergenz etwas angepasst) mit seinen zwei Linsen 16a und 16b - wie in der Figur 1 angedeutet - in der zweiten Umwegleitung 11 wieder hergestellt. In einer Alternative zur Erfindung kommt dafür auch eine Einzellinse in Frage.

Selbstverständlich ist es jedoch auch möglich, den vorstehend genannten Aufbau zu erweitern und z.B. noch weitere Umwegleitungen vorzusehen, soweit dies räumlich praktikabel erscheint und eine weitere Absenkung der Spitzenleistungen noch Vorteile bringt.

In einer Alternative zur Erfindung ist es auch denkbar, den Strahl physikalisch zu teilen statt polarisationsoptisch. Wenn die Peakleistung einer Pulslaser-Lichtquelle z.B. durch einen entsprechenden zeitlichen Versatz der Teilstrahlen um die Hälfte reduziert wird, so reduziert sich die Gefahr von Schädigungen für Bauteile nicht nur um die Hälfte, sondern sogar noch mehr. Da die "Peaks" in den einzelnen Puls strukturiert sind, was durch die Resonatorlänge in dem Laser kommt, lässt sich bereits mit kurzen Verzögerungswegen erreichen, dass der Puls innerhalb seiner Länge versetzt und die Strukturierung entsprechend ausgenutzt wird, womit eine deutliche Abflachung erreicht werden kann. Aufgrund der Struktur der Pulse von Pulslaser-Lichtquellen lassen sich dabei schon durch geringe Umwegleitungen die Leistungsspitzen klar reduzieren. Ein Optimum wird selbstverständlich dann erreicht, wenn die zeitliche Verschiebung durch die Strahlaufteilung so groß ist, dass sich jeweils "Peaks" und Täler zuordnen lassen. Dies lässt sich z.B. durch die zweite Umwegleitung 11 erreichen. Anstelle der Spiegel als reflektierende Bauteile können auch andere reflektierende Bauteile, wie z.B. Prismen, vorgesehen werden.

Erzeugt man durch eine λ/4-Platte (nicht dargestellt)vor der Einrichtung zirkularpolarisiertes Licht, ist jeder azimutale Winkel um die Z Achse für die Strahlteilereinrichtungen 3 und 4 möglich.

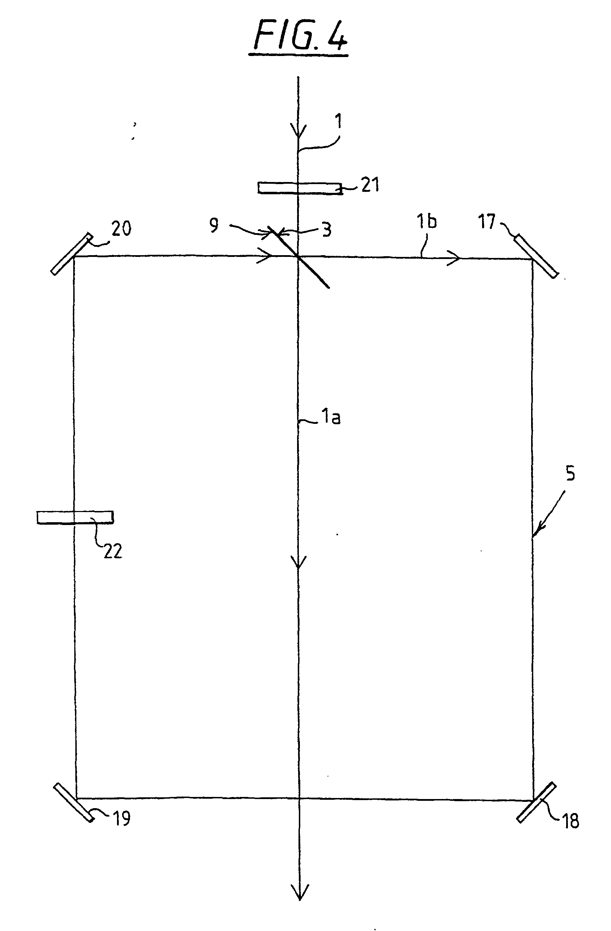

In der Figur 4 ist eine weitere Ausführungsform einer Umwegleitung prinzipmäßig dargestellt. Wie ersichtlich, erfolgt eine Aufteilung des Strahlenbündels 1 an der Strahlteilereinrichtung 3 in einen Teilstrahl 1a, der durch die Strahlteilereinrichtung 3 hindurchgeht, und einen Teilstrahl 1b, der den Weg über die rechteckige Umwegleitung 5 nimmt. Die Umwegleitung 5 wird dabei durch vier Spiegel 17, 18, 19 und 20 gebildet, bevor der Teilstrahl 1b auf der Rückseite der Strahlteilereinrichtung 3, die ebenso wie bei dem Ausführungsbeispiel nach der Figur 1 als Strahlvereinigungsglied 9 dient, wieder mit dem Teilstrahl 1a vereinigt wird.

Im Unterschied zu dem Ausführungsbeispiel nach der Figur 1 erfolgt dabei jedoch nicht eine vollständige Vereinigung, sondern die Ausführungsform nach der Figur 4 ist so ausgestaltet, dass ein Anteil des über die Umwegleitung 5 gelaufenen Teilstrahles 1b ein weiteres Mal den Weg über die Umwegleitung 5 nimmt, wobei dies mehrfach durchgeführt werden kann. Die Einkoppelung des Strahles erfolgt bei diesem Ausführungsbeispiel nach Art eines Resonators, wobei der Anteil des über die Umwegleitung 5 umlaufenden Lichtes bzw. Teilstrahles 1b, d.h. die einstellbare Pulslänge, von dem Zustand der Polarisation abhängt. Auf diese Weise können beliebige Verzögerungen der eintreffenden Pulse und eine damit verbundene Absenkung der Pulsspitzenenergie der Pulslaser-Lichtquelle erreicht werden. Dabei ist lediglich dafür zu sorgen, dass ein Optimum zwischen einer zeitlichen Streckung der Teilpulse (Anzahl der Resonator-Umläufe) und der Gesamtverluste gewählt wird. Erreicht wird dies durch die Anordnung einer Phasenverzögerungsplatte 21 im Strahlengang vor der Strahlerteileinrichtung 3 und einer weiteren Phasenverzögerungsplatte 22 in der Umwegleitung 1b. Auf diese Weise wird aus einem linearpolarisierten Licht ein leicht elliptisch polarisiertes Licht gemacht, welches beim Durchgang durch die Strahlteilereinrichtung 3 mit einer entsprechenden Komponente ausgespiegelt wird. Die Höhe der Komponente hängt dabei vom Grad der Ellipse ab. Rüstet man z.B. die Phasenverzögerungsplatte 21 mit einem λ/4-Wert aus, dann wird ein Betrag in Höhe von 50 % über die Umwegleitung 1b geschickt. In der Praxis wird man λ-Werte zwischen 0 und einem Viertel wählen.

Die Ausgestaltung nach der Figur 4 mit den beiden Phasenverzögerungsplatten 21 und 22 hat den Vorteil, dass auf diese Weise die Vorrichtung sehr variabel eingesetzt werden kann. Wechselt man nämlich eine oder beide Phasenverzögerungsplatten 21 bzw. 22 aus, so ändert sich entsprechend die Spitzenleistung. Möchte man z.B. eine höhere Leistung erreichen, womit zwangsweise eine höhere Belastung und damit eine kürzere Lebensdauer für die Vorrichtung entsteht, so wird man Phasenverzögerungsplatten 21 bzw. 22 einsetzen, die entsprechend weniger Umläufe erzwingen. Umgekehrt kann man auf diese Weise auch durch eine entsprechende Erhöhung der Anzahl der Umläufe des Lichtes eine Schonung der optischen Bauteile der Projektionsbelichtungsanlage erreichen.

In der Figur 5 ist prinzipmäßig die Einsatzstelle der Vorrichtung 23 dargestellt. Die polarisierte Lichtquelle 2 ist danach für eine Projektionsbelichtungsanlage vorgesehen, die sich in einem durch eine Wand 17 von der Umgebung getrennten Reinraum mit einer Beleuchtungsoptik 18, einer Maske 19, einem Projektionsobjektiv 20 und einem Laser 21 befindet. Um den Reinraum möglichst wenig zu beeinflussen, wird dabei die Vorrichtung 23, die im Inneren mit den in Figur 1 dargestellten Teilen versehen ist, zwischen der Pulslaser-Lichtquelle 2 und der Wand 17 in dem Strahlengang 1 der Pulslaser-Lichtquelle 2 angeordnet.

## Patentansprüche

1. Projektionsbelichtungsanlage mit einer Vorrichtung zur Reduzierung der Peakleistung einer polarisiertes Licht erzeugenden Pulslaser-Lichtquelle, wobei in dem Strahlengang der Pulslaser-Lichtquelle wenigstens eine Strahlteilereinrichtung (3) angeordnet ist, durch die über reflektierende Bauteile (6,7,8 bzw. 12,13,14) wenigstens eine Umwegleitung für wenigstens einen Teilstrahl erzeugt wird, wobei im Strahlengang (1) ein Strahlvereinigungsglied (9) angeordnet ist, in oder an dem die Teilstrahlen (1a,10a,1b,10b) wieder zu einem Gesamtstrahl vereinigt werden, wobei die Strahlteilereinrichtung (3) in einem Winkel zum Strahlengang (1) angeordnet ist, der dem Brewster-Winkel entspricht, und wobei in der wenigstens einen Umwegleitung (5,11) ein leicht verstimmtes Kepler-Fernrohr (16a,16b) angeordnet ist.

2. Vorrichtung nach Anspruch 1, **dadurch gekennzeichnet, dass** die Umwegleitung (5 bzw. 11) eine derartige Länge aufweist, dass sich ein optischer Gangunterschied der Teilstrahlen (1a,1b bzw. 10a,10b) von über 0,5 m ergibt.

3. Vorrichtung nach Anspruch 1 oder 2, **dadurch gekennzeichnet, dass** wenigstens drei reflektierende Bauteile (6,7,8 bzw. 12,13,14)eine Umwegleitung (5 bzw. 11) bilden.

4. Vorrichtung nach einem der Ansprüche 1 bis 3, **dadurch gekennzeichnet, dass** als Strahlteilereinrichtung Spiegel (3, 4) vorgesehen sind.

5. Vorrichtung nach einem der Ansprüche 1 bis 4, **dadurch gekennzeichnet, dass** die reflektierenden Bauteile als Spiegel (6,7,8 bzw. 12,13,14) ausgebildet sind.

6. Vorrichtung nach einem der Ansprüche 1 bis 5, **dadurch gekennzeichnet, dass** zwei Umwegleitungen (5,11) im Strahlengang (1) hintereinander angeordnet sind.

7. Vorrichtung nach Anspruch 6, **dadurch gekennzeichnet, dass** eine erste Umwegleitung (5) eine Länge von über 2 m und eine zweite Umwegleitung (11) eine Länge von über 10 m aufweist.

8. Vorrichtung nach einem der Ansprüche 1 bis 7, **dadurch gekennzeichnet, dass** das Strahlvereinigungsglied (9,15) derart ausgebildet ist, dass ein Teil des Teilstrahles (1b bzw. 10b), der über die Umwegleitung (5 bzw. 11) gelaufen ist, wiederholt über die Umwegleitung (5 bzw. 11) geschickt wird.

9. Vorrichtung nach Anspruch 8, **dadurch gekennzeichnet, dass** wenigstens eine Phasenverzögerungsplatte (21,22) im Strahlengang angeordnet ist.

10. Vorrichtung nach Anspruch 9, **dadurch gekennzeichnet, dass** eine Phasenverzögerungsplatte (21) im Strahlengang (1) vor der Strahlteilereinrichtung (3) und wenigstens eine weiter Phasenverzögerungsplatte (22) in der Umwegleitung (5) angeordnet ist.

## Claims

1. A projection printing system having a device for reducing the peak output of a pulsed laser light source generating polarised light, wherein there is arranged in the beam path of the pulsed laser light source at least one beam splitter means (3), by means of which at least one diversion line for at least one sub-beam is generated via reflecting components (6, 7, 8 or 12, 13, 14), wherein a beam recombining member (9) is arranged in the beam path (1), in or at which member (9) the sub-beams (1a, 10a, 1b, 10b are reunited into a total beam, wherein the beam splitter means (3) is arranged at an angle to the beam path (1) which corresponds to the Brewster angle, and wherein in the at least one diversion line (5, 11) there is arranged a slightly detuned Keplerian telescope (16a, 16b) .

2. A device according to claim 1, **characterised in that** the diversion line (5 or 11) exhibits such a length as to result in an optical path difference of the sub-beams (1a, 1b or 10a, 10b respectively) of over 0.5 m.

3. A device according to claim 1 or claim 2, **characterised in that** at least three reflecting components (6, 7, 8 or 12, 13, 14) form a diversion line (5 or 11 respectively).

4. A device according to one of claims 1 to 3, **characterised in that** mirrors (3, 4) are provided as the beam splitter means.

5. A device according to one of claims 1 to 4, **characterised in that** the reflecting components take the form of mirrors (6, 7, 8 or 12, 13, 14).

6. A device according to one of claims 1 to 5, **characterised in that** two diversion lines (5, 11) are arranged in succession in the beam path (1).

7. A device according to claim 6, **characterised in that** a first diversion line (5) exhibits a length of over 2 m and a second diversion line (11) exhibits a length of over 10 m.

8. A device according to one of claims 1 to 7, **characterised in that** the beam recombining member (9, 15) is so constructed that part of the sub-beam (1b or 10b respectively), which has passed along the diversion line (5 or 11), is sent along the diversion line (5 or 11) repeatedly.

9. A device according to claim 8, **characterised in that** at least one phase lag plate (21, 22) is arranged in the beam path.

10. A device according to claim 9, **characterised in that** one phase lag plate (21) is arranged in the beam path (1) upstream of the beam splitter means (3) and at least one further phase lag plate (23) is arranged in the diversion line (5).

## Revendications

1. Installation d'éclairage pour projection avec un dispositif de réduction de la puissance de crête d'une source lumière à laser à impulsions produisant une lumière polarisée, dans laquelle au moins un dispositif de séparation de faisceaux (3), à l'aide duquel, par l'intermédiaire d'éléments réfléchissants (6, 7, 8 resp. 12, 13, 14) au moins une déviation est générée pour au moins un faisceau partiel, se trouve dans le trajet des rayons de la source de lumière à laser à impulsions, dans laquelle un élément de réunification des faisceaux (9), dans ou au niveau duquel les faisceaux partiels (1a, 10a, 1b, 10b) sont à nouveau réunis en un faisceau unique, se trouve dans le trajet des faisceaux (1), dans laquelle le dispositif de séparation de faisceaux (3) forme avec le trajet des faisceaux (1) un angle qui correspond à l'angle de Brewster, et dans laquelle une lunette de Kepler (16a, 16b) légèrement décalée se trouve dans au moins une des déviations (5, 11).

2. Dispositif selon la revendication 1, **caractérisé en ce que** la déviation (5 resp. 11) a une longueur telle qu'une différence de trajet de plus de 0,5 m est obtenue entre les faisceaux partiels (1a, 1b resp. 10a, 10b).

3. Dispositif selon la revendication 1 ou 2, **caractérisé en ce qu'**au moins trois éléments réfléchissants (6, 7, 8 resp. 12, 13, 14) constituent une déviation (5 resp. 11).

4. Dispositif selon l'une des revendications 1 à 3, **caractérisé en ce que** des miroirs (3, 4) sont utilisés en tant que dispositif de séparation de faisceaux.

5. Dispositif selon l'une des revendications 1 à 4, **caractérisé en ce que** les éléments réfléchissants sont conçus comme des miroirs (6, 7, 8 resp. 12, 13, 14).

6. Dispositif selon l'une des revendications 1 à 5, **caractérisé en ce que** deux déviations (5, 11) sont disposées l'une derrière l'autre dans le trajet des faisceaux (1).

7. Dispositif selon la revendication 6, **caractérisé en ce qu'**une première déviation (5) a une longueur de plus de 2 m et une deuxième déviation (11) a une longueur de plus de 10 m.

8. Dispositif selon l'une des revendications 1 à 7, **caractérisé en ce que** l'élément de réunification des faisceaux (9, 15) est agencé de telle sorte qu'une partie du faisceau partiel (1b resp. 10b) qui a parcouru la déviation (5 resp. 11) est à nouveau envoyé dans la déviation (5 resp. 11).

9. Dispositif selon la revendication 8, **caractérisé en ce qu'**au moins une plaque de déphasage (21, 22) se trouve dans le trajet des faisceaux.

10. Dispositif selon la revendication 9, **caractérisé en ce qu'**une plaque de déphasage (21) se trouve dans le trajet des faisceaux (1) avant le dispositif de séparation des faisceaux (3) et au moins une autre plaque de déphasage (22) se trouve dans la déviation (5).
